Europäisches Patentamt

European Patent Office

Office européen des brevets

(11) Veröffentlichungsnummer: **0 060 928**
A1

(12) ## EUROPÄISCHE PATENTANMELDUNG

(21) Anmeldenummer: **81109146.1**

(22) Anmeldetag: **28.10.81**

(51) Int. Cl.³: **H 03 L 1/02**
**H 03 B 5/04**

(30) Priorität: **25.03.81 DE 3111736**

(43) Veröffentlichungstag der Anmeldung:
**29.09.82 Patentblatt 82/39**

(84) Benannte Vertragsstaaten:
**AT BE CH FR GB IT LI NL SE**

(71) Anmelder: **SIEMENS AKTIENGESELLSCHAFT Berlin
und München
Postfach 22 02 61
D-8000 München 22(DE)**

(72) Erfinder: **Hanni, Manfred, Ing. grad.
Gottschalkstrasse 3
D-8039 Puchheim(DE)**

(72) Erfinder: **Rittenauer, Bodo, Dipl.-Math.
Wilhelm-Weitling-Strasse 16
D-8000 München 70(DE)**

(54) Taktgeneratoranordnung mit Temperaturkompensation.

(57) Die Erfindung betrifft eine Taktgeneratoranordnung mit einem Quarz-Grundtaktgenerator (GG) und einem dem Quarz-Grundtaktgenerator nachgeschalteten durch Stellimpulse gesteuerten digitalen Phasenschieber (Ph) für nachrichtentechnische Geräte, insbesondere Funkgeräte. Zum Ausregeln der Frequenzdrift des Quarzes (QZ) zum Erzielen einer verbesserten Frequenzstabilität der am Ausgang des digitalen Phasenschiebers auftretenden Taktpulsfolge ist ein Temperaturdisktriminator (TD) vorgesehen. Der Temperaturdiskriminator erhält über einen Temperatursensor (TS) Angaben über die Umgebungstemperatur des Quarzes und leitet davon entsprechende Stellimpulse für den digitalen Phasenschieber ab.

FIG 1

EP 0 060 928 A1

SIEMENS AKTIENGESELLSCHAFT          Unser Zeichen
Berlin und München                  VPA 81 P 6 8 5 9 E

Taktgeneratoranordnung      BEZEICHNUNG GEÄNDERT
                            siehe Titelseite

Die Erfindung bezieht sich auf eine Taktgeneratoranordnung, bestehend aus einem Grundtaktgenerator mit einem
Piezokristall, vorzugsweise ein Quarzkristall, als frequenzbestimmendes Element, sowie einem durch Stellimpulse gesteuerten digitalen Phasenschreiber.

Taktgeneratoranordnungen dieser Art sind beispielsweise
durch die DE-PS 27 38 648 bekannt. Quarzoszillatoren haben
zwar bekanntlich eine relativ hohe Frequenzstabilität, lassen sich jedoch nur in sehr geringen Grenzen in ihrer Frequenz variieren. Durch die Kombination eines Quarzoszillators mit einem ihm nachgeschalteten digitalen steuerbaren
Phasenschieber wird es möglich, Oszillatoren zu realisieren, die bei einer durch den Quarz vorgegebenen hohen Frequenzstabilität in einem größeren Frequenzbereich variierbar sind.

Die Frequenzstabilität von Quarzoszillatoren liegt bei ausgesuchten Quarzen ohne Verwendung eines Thermostaten in
der Größenordnung von $1 \cdot 10^{-5}$ im Temperaturbereich von
z.B. $0 \div 40^{\circ}$C. Mit Hilfe eines Einfachthermostaten läßt sich
die Frequenzstabilität auf ca $1 \cdot 10^{-7}$ erhöhen. Wird aber
eine Frequenzstabilität von $1 \cdot 10^{-9}$ angestrebt, dann ist
dies nur unter Einsatz eines ganz erheblichen Aufwandes
möglich. Der besonders ausgesuchte Quarz muß künstlich
gealtert und darüberhinaus in einem Doppelthermostaten
untergebracht werden, der einen erheblichen Energie- und
Raumbedarf in Anspruch nimmt. Quarzoszillatoren mit einer
so hohen Frequenzstabilität werden in zunehmendem Maße bei

Jae 1 Obh / 24.3.1981          6 Ausfertigungen
                               1. Ausfertigung

Funkgeräten für taktischen Einsatz benötigt, weil die Synchronisation von mit solchen Grundtaktgeneratoren ausgerüsteten, miteinander in Betrieb befindlichen Stationen außerordentlich resistent gegen gezielte Fremdstörung gestaltet werden kann.

Der für die hohe Frequenzstabilität erforderliche erwähnte Aufwand hinsichtlich Volumen und Energieverbrauch steht anderen Forderungen entgegen, die im allgemeinen bei mobilen Funkgeräten gestellt werden. Ein mobiles Funkgerät soll nämlich möglichst klein, robust und leicht sein und darüberhinaus auch einen möglichst geringen Energiebedarf haben.

Der Erfindung liegt die Aufgabe zugrunde, für eine Taktgeneratoranordnung der einleitend beschriebenen Art eine weitere Lösung anzugeben, die auch bei hohen Anforderungen an die Frequenzstabilität gegenüber bekannten Anordnungen mit einem wesentlich geringeren Volumen auskommt und darüberhinaus auch eine wesentliche Energieersparnis mit sich bringt.

Ausgehend von einer Taktgeneratoranordnung, bestehend aus einem Grundtaktgenerator mit einem Piezokristall, vorzugsweise ein Qaurzkristall, als frequenzbestimmendes Element, sowie einem durch Stellimpulse gesteuerten digitalen Phasenschieber, wird diese Aufgabe gemäß der Erfindung dadurch gelöst, daß die Umgebungstemperatur des Piezokristalls des Grundtaktgenerators mittels eines Temperatursensors fortlaufend überwacht ist, daß ferner aus den Temperatursignalwerten des Temperatursensors in einem Temperaturdiskriminator Phasenkorrekturwerte ermittelt und hiervon abhängig fortlaufend die Stellimpulse für den digitalen Phasenschieber erzeugt sind, die im Sinne einer Verbesserung der Frequenzstabilität der am Ausgang des digitalen Phasenschiebers abgegebenen Taktpulsfolge die
Phase der Schwingung des Grundtaktgenerators schrittweise korrigieren.

Der Erfindung liegt die Erkenntnis zugrunde, daß das Temperaturverhalten eines vorgegebenen Schwingquarztyps nur eine geringe Exemplarstreuung aufweist und es somit möglich ist, die Temperaturdrift des Quarzes über eine entsprechende Steuerung des digitalen Phasenschiebers für die phasenschieberausgangsseitige Taktpulsfolge wenigstens annähernd zu kompensieren. Es ist also mit anderen Worten möglich, auch billige Schwingquarze ohne größere Aufwendungen für ihre Temperaturstabilität zur Erzeugung von Taktpulsfolgen heranzuziehen, deren Frequenzstabilität um Größenordnungen besser ist als die Frequenzstabilität des Quarzes unter den gegebenen Bedingungen.

Der digitale Phasenschieber besteht zweckmäßig aus der Hintereinanderschaltung einer von den Stellimpulsen gesteuerten Ein-Ausblendvorrichtung für Einzelimpulse mit nachgeschalteter digitaler Frequenzverteilerkette.

Bei einer bevorzugten Ausführungsform ist der Temperaturdiskriminator ein Mikroprozessor mit einem Temperatur-Festwertspeicher, in den in Form einer Tabelle die der Temperatur des Piezokristalls des Grundtaktgenerators zugehörigen Phasenkorrekturwerte eingespeichert sind. Der Mikroprozessor frägt hierbei zur Erzeugung der Stellimpulsfolge fortlaufend für die vom Temperatursensor ermittelten Temperatursignalwerte die zugehörigen Phasenkorrekturwerte aus dem Temperatur-Festwertspeicher ab.

Bekanntlich unterliegen Schwingquarze in Abhängigkeit ihrer Betriebsdauer einem Alterungsprozeß, der in Form einer Langzeitfrequenzdrift zum Ausdruck kommt. Grundsätzlich besteht die Möglichkeit, diese Langzeitdrift durch Nachstellen der Quarzgrundfrequenz mittels eines Ziehkondensators in größeren Zeitabständen für die Taktgeneratoranordnung zu kompensieren. Nachdem jedoch auch hinsichtlich des Frequenzverlaufs über der Betriebsdauer Schwingquarze eines bestimmten Fertigungstyps ebenfalls nur eine relativ kleine Exemplarstreuung aufweisen, wird in Weiterbildung der Erfindung vorgeschlagen, dem Mikroprozessor zusätzlich einen Alterungs-Festwertspeicher zuzuordnen, in den in Form eines Kalenders die der Alterungsabweichung des Piezo-kristalls des Grundtaktgenerators zugehörigen Phasenkorrek-turwerte eingespeichert sind. Der Mikroprozessor liest hierbei mittels einer die Betriebsdauer des Grundtaktgenerators anzeigenden Digitaluhr jeweils den der Betriebsdauer zugehörigen Phasenkorrekturwert aus dem Alterungs-Festwertspeicher aus und bildet zur Erzeugung der Stellimpulsfolge aus diesem Phasenkorrekturwert und dem jeweils aus dem Temperatur-Festwertspeicher ausgelesenen Phasenkorrekturwert einen Summen-Phasenkorrekturwert.

Bei Anwendung der vorliegenden Erfindung zur Realisierung einer Taktgeneratoranordnung mit einer Frequenzstabilität von bis zu ca. $1 \cdot 10^{-9}$ in einem vorgegebenen Temperaturbe-reich ist es sinnvoll, wenn der Grundtaktgenerator für eine Frequenzstabilität von $1 \cdot 10^{-7}$ ausgelegt und hierzu der Piezokristall in einen Einfachthermostaten eingebracht wird.

Anhand eines in der Zeichnung dargestellten Ausführungsbeispiels soll die Erfindung im folgenden noch näher erläutert werden. In der Zeichnung bedeuten

Fig. 1 das Blockschaltbild einer Taktgeneratoranordnung nach der Erfindung,

Fig. 2 ein nähere Einzelheiten aufweisendes Blockschaltbild der Taktgeneratoranordnung nach Fig. 1,

Fig. 3 die Taktgeneratoranordnung nach den Fig. 1 und 2
näher erläuternde Zeitdiagramme.


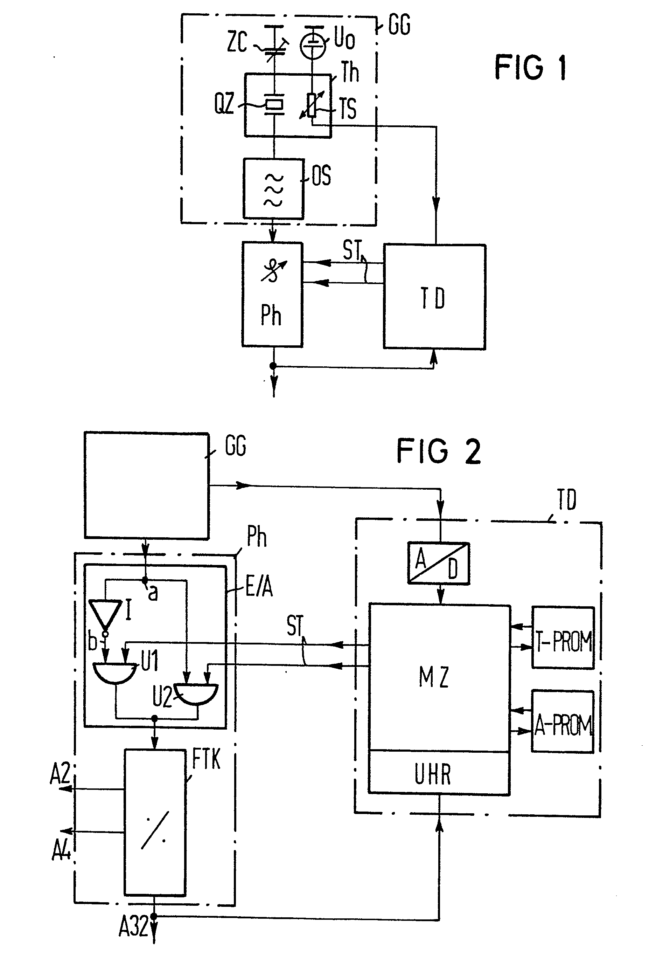

Das Blockschaltbild nach Fig. 1 weist den Grundtaktgenerator GG auf, dem ausgangsseitig der digitale Phasenschieber Ph nachgeschaltet ist. Weiterhin ist der Temperaturdiskriminator TD vorgesehen, der seinen Takt vom Ausgang
des digitalen Phasenschiebers Ph erhält, und der über die
Steuerleitungen St dem digitalen Phasenschieber Ph Stellimpulse zuführt. Weiterhin erhält der Temperaturdiskriminator TD Temperatursignalwerte von dem Temperatursensor Ts,
der zusammen mit dem Quarz QZ in dem Einfachthermostat Th
untergebracht ist. Der Quarz QZ ist seinerseits über den
Ziehkondensator ZC und der Temperatursensor TS über die
Betriebsgleichspannungsquelle Uo gegen Bezugspotential
gelegt. Außer dem in Thermostaten angeordneten Quarz QZ
und dem Ziehkondensator ZC weist der Grundtaktgenerator
GG noch die eigentliche Oszillatorschaltung OS auf.


Wie das nähere Einzelheiten aufweisende Blockschaltbild
nach Fig. 2 zeigt, besteht der digitale Phasenschieber Ph
aus der Hintereinanderschaltung der Einblend-Ausblendvorrichtung E/A und der Frequenzteilerkette FTK mit verschiedenen Teilerausgängen A2, A4 und A32, von denen der Ausgang A32 den eigentlichen Ausgang des digitalen Phasenschiebers Ph darstellt. Jeder Stellimpuls bewirkt somit
bei der am Ausgang A32 auftretenden Taktpulsfolge entsprechend einem Teilungsfaktor von 32 eine Phasenverschiebung
um 1/32 Bit.

Die Einblend-Ausblendvorrichtung E/A weist im wesentlichen
zwei UND-Gatter U1 und U2 auf, deren jeweils erster Eingang vom Ausgang des Grundtaktgenerators GG einmal unmittelbar und zum anderen Mal über den Inverter I angesteuert
wird. Die jeweils zweiten Eingänge der UND-Gatter U1 und
U2 sind mit den zum Temperaturdiskriminator TG führenden
Steuerleitungen ST verbunden.

Der Temperaturdiskriminator TD besteht im wesentlichen aus dem Mikroprozessor MZ, dessen Peripherie einen Analog-Digitalwandler A/D für die vom Temperatursensor übermittelten Temperatursignalwerte, einen Temperatur-Festwertspeicher T-PROM, einen Alterungs-Festwertspeicher A-PROM und eine Digitaluhr UHR aufweist. Dabei ist in den Temperatur-Festwertspeicher T-PROM die Temperatur-Korrekturtabelle und in den Alterungs-Festwertspeicher A-PROM die Alterungs-Korrekturwerttabelle eingespeichert. Der Mikroprozessor MZ liest in Abhängigkeit der ihm zugeführten Temperatursignalwerte aus dem Temperatur-Festwertspeicher fortlaufend Temperatur-Korrekturwerte und aus dem Alterungs-Festwertspeicher in Abhängigkeit der von der Digitaluhr UHR angezeigten Betriebsdauer die zugehörigen Korrekturwerte aus, bildet daraus Summen-Korrekturwerte, aus denen dann die erforderlichen Stellimpulse fortlaufend erzeugt und über die Steuerleitungen ST an die Einblend-Ausblendvorrichtung E/A abgegeben werden.

Zur Gewinnung der Temperatur- und der Alterungs-Korrekturwerttabelle können Mittelwerte für das Temperatur- und Alterungsverhalten einer größeren Anzahl von ggfs. ausgesuchten Quarzen eines bestimmten Typs herangezogen werden. Bei höheren Anforderungen an die Frequenzstabilität ist es jedoch wenigstens für die Erstellung der Temperatur-Korrekturwerttabelle sinnvoll, für jeden Quarz eine individuelle Tabelle zu erstellen. Hierzu wird beispielsweise die Quarzfrequenz in Abhängigkeit der Temperatur über einen vorgegebenen Bereich, beispielsweise $0^{\circ}C$-$40^{\circ}C$ hinweg mit einem Frequenznormal verglichen und die Abweichungen festgehalten.

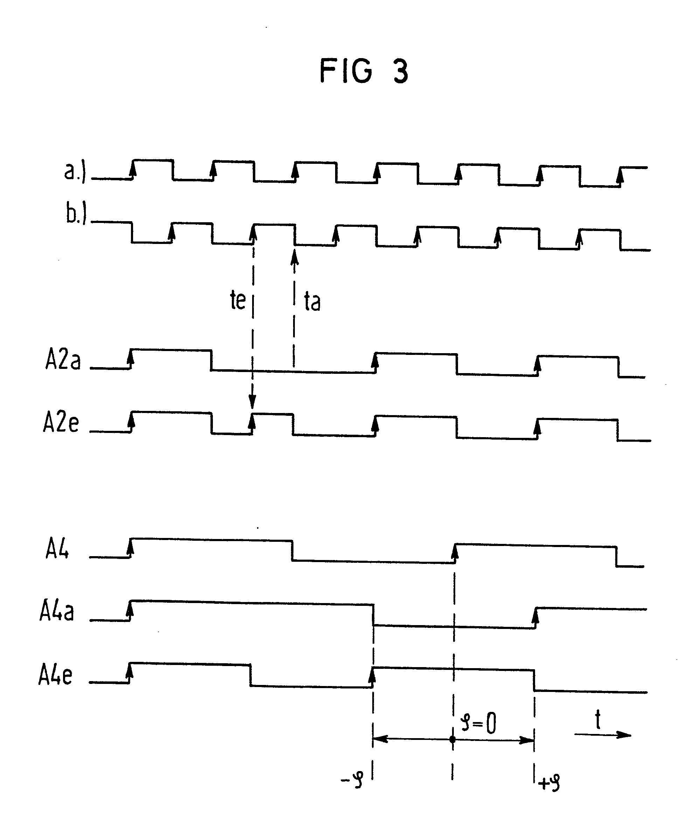

Der Vorgang der Ein- und Ausblendung von Einzelimpulsen mittels der Einblend-Ausblendvorrichtung E/A soll anhand der Zeitdiagramme in Fig. 3 nunmehr noch näher erläutert werden. Die Bezeichnungen der einzelnen Zeitdiagramme stimmen dabei mit den Ortsbezeichnungen in Fig. 2 überein, an denen die in den vorbezeichneten Zeitdiagrammen
angegebenen Spannungsverläufe auftreten.

Das oberste Diagramm a zeigt die am Ausgang des Grundtaktgenerators GG auftretende Rechteckschwingung. Diese Rechteckschwingung wird, wie das Diagramm b zeigt, über den Inverter I in der Phase umgekehrt. Jeweils aufsteigende Flanken der Rechteckimpulsfolgen a und b sind mit einem Pfeil
markiert. Die der Einblend-Ausblendvorrichtung E/A nachgeschaltete Frequenzteilerkette ist so gestaltet, daß sie
jeweils auf die aufsteigenden Flanken der Rechteckschwingung nach den Diagrammen a und b ansprechen.

Es sei angenommen, daß im Zeitpunkt ta dem zweiten Eingang
des UND-Gatters U2 ein Sperrimpuls und im Zeitpunkt te
dem zweiten Eingang des UND-Gatters U1 ein Öffnungsimpuls
zugeführt werden. Ein Sperrimpuls im Zeitpunkt ta am UND-
Gatter U2 bedeutet eine negative Phasenverschiebung und
ein Öffnungsimpuls am zweiten Eingang des UND-Gatters U1
eine positive Phasenverschiebung. Die entsprechenden Rechteckimpulsfolgen am Ausgang A2 der Frequenzteilerkette nach
einer Frequenzteilung um den Faktor zwei zeigen die Diagramme A2a und A2e. a bedeutet dabei Ausblendung und e
Einblendung. Das entsprechende Ergebnis am Ausgang A4 nach
einer vierfachen Frequenzteilung zeigen die Diagramme A4a
und A4e, denen in Gestalt des Diagramms A4 die Rechteckimpulsfolge noch beigegeben ist, die bei fehlenden Stellimpulsen am Ausgang A4 auftritt. In den Diagrammen A4a
und A4e sind die Phasenverschiebungen $-\varphi$ und $+\varphi$ gegenüber der Phase $\varphi = 0$ ebenfalls angegeben.

5 Patentansprüche

3 Figuren

0060928

VPA 81 P 6859 E

Patentansprüche

1. Taktgeneratoranordnung, bestehend aus einem Grundtaktgenerator mit einem Piezokristall, vorzugsweise ein Quarzkristall, als frequenzbestimmendes Element, sowie einem
durch Stellimpulse gesteuerten digitalen Phasenschieber,
d a d u r c h   g e k e n n z e i c h n e t , daß die
Umgebungstemperatur des Piezokristalls (QZ) des Grundtaktgenerators (GG) mittels eines Temperatursensors (TS) fortlaufend überwacht ist, daß ferner aus den Temperatursignalwerten des Temperatursensors in einem Temperaturdiskriminator (TD) Phasenkorrekturwerte ermittelt und hiervon abhängig fortlaufend die Stellimpulse für den digitalen Phasenschieber (Ph) erzeugt sind, die im Sinne einer Verbesserung der Frequenzstabilität der am Ausgang des digitalen
Phasenschiebers abgegebenen Taktpulsfolge die Phase der
Schwingung des Grundtaktgenerators schrittweise korrigieren.

2. Taktgeneratoranordnung nach Anspruch 1,
d a d u r c h   g e k e n n z e i c h n e t , daß der
digitale Phasenschieber (Ph) aus der Hintereinanderschaltung einer von den Stellimpulsen gesteuerten Ein-Ausblendvorrichtung (E/A) für Einzelimpulse mit nachgeschalteter
digitaler Frequenzteilerkette (FTK) besteht.

3. Taktgeneratoranordnung nach Anspruch 1 oder 2,
d a d u r c h   g e k e n n z e i c h n e t , daß der
Temperaturdiskriminator (TD) ein Mikroprozessor (MZ) mit
einem Temperatur-Festwertspeicher (T-PROM) ist, in den in
Form einer Tabelle die der Temperatur des Piezokristalls
(QZ) des Grundtaktgenerators (GG) zugehörigen Phasenkorrekturwerte eingespeichert sind, und daß der Mikroprozessor
zur Erzeugung der Stellimpulsfolge fortlaufend für die
vom Temperatursensor ermittelten Temperatursignalwerte die zugehörigen Phasenkorrekturwerte aus dem Temperatur-Festwertspeicher abfrägt.

4. Taktgeneratoranordnung nach Anspruch 3, d a d u r c h   g e k e n n z e i c h n e t , daß dem Mikroprozessor (MZ) zusätzlich ein Alterungs-Festwertspeicher (A-PROM) zugeordnet ist, in den in Form eines Kalenders die der Alterungsabweichung des Piezokristalles (QZ) des Grundtaktgenerators (GG) zugehörigen, Phasenkorrekturwerte eingespeichert sind und daß der Mikroprozessor mittels einer die Betriebsdauer des Grundtaktgenerators anzeigenden Digitaluhr (UHR) jeweils den der Betriebsdauer zugehörigen Phasenkorrekturwert aus dem Alterungs-Festwertspeicher ausliest und zur Erzeugung der Stellimpulsfolge aus diesem Phasenkorrekturwert und dem jeweils aus dem Temperatur-Festwertspeicher (T-PROM) ausgelesenen Phasenkorrekturwert einen Summen-Phasenkorrekturwert bildet.

5. Taktgeneratoranordnung mit einer Frequenzstabilität von bis ca. $1 \cdot 10^{-9}$ in einem vorgegebenen Temperaturbereich nach einem der vorhergehenden Ansprüche, d a d u r c h   g e k e n n z e i c h n e t , daß der Grundtaktgenerator (GG) für eine Frequenzstabilität von ca. $1 \cdot 10^{-7}$ ausgelegt und hierzu der Piezokristall (QZ) in einen Einfachthermostaten (Th) eingebracht ist.

FIG 1

FIG 2

FIG 3

# EUROPÄISCHER RECHERCHENBERICHT

**0060928**

Nummer der Anmeldung

EP 81 10 9146

Europäisches Patentamt

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | ELECTRONICS, Band 45, Nr. 17, 14. August 1972, Seiten 124-126 New York, U.S.A. J.W.L. PRAK et al.: "Digital ICs set temperature compensation for oscillators"<br><br>* Seite 126, die letzten beiden Absätze; Figur 4 * <br><br>-- | 1,2 |
| X | DE - A - 2 742 908 (SIEMENS)<br><br>* Ansprüche 1,2; Seite 3, Zeile 28 - Seite 4, Zeile 7; Figur 1 *<br><br>-- | 1-4 |
| | PROCEEDINGS OF THE TWENTY-SEVENTH ANNUAL FREQUENCY CONTROL SYMPOSIUM, 12.-14. Juni 1973, Seiten 191-198 Washington, U.S.A. G.E. BUROKER et al.: "A digitally compensated TCXO"<br><br>* Insgesamt *<br><br>-- | 1-5 |
| | GB - A - 2 018 473 (SUWA SEIKOSHA)<br><br>* Insgesamt *<br><br>-- | 2-4 |
| A | US - A - 3 999 370 (MOROKAWA et al.)<br><br>* Zusammenfassung; Figuren 4,16, 18. *<br><br>& DE - A - 2 406 130<br><br>-- <br><br>./. | 1,2 |

**KLASSIFIKATION DER ANMELDUNG (Int Cl³)**

H 03 L 1/02
H 03 B 5/04

**RECHERCHIERTE SACHGEBIETE (Int. Cl.³)**

H 03 L 1/02
        1/00
H 04 L 7/02

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 19-11-1981 | DHONDT |

EPA form 1503.1   06.78

# 0060928

Nummer der Anmeldung

**Europäisches Patentamt**

## EUROPÄISCHER RECHERCHENBERICHT

EP 81 10 9146

-2-

| | EINSCHLÄGIGE DOKUMENTE | | KLASSIFIKATION DER ANMELDUNG (Int. Cl.³) |
|---|---|---|---|
| Kategorie | Kennzeichnung des Dokuments mit Angabe, soweit erforderlich, der Maßgeblichen Teile | betrifft Anspruch | |
| A | FR - A - 2 322 478 (SEIKOSHA) <br> * Seite 3, Zeile 12 - Seite 4, Zeile 22; Figur 4 * <br><br> -- | 1 | |
| A | US - A - 3 805 192 (OCNASCHEK et al.) <br> * Figur * <br><br> -- | | |
| DA | DE - C - 2 738 648 (SIEMENS) <br> * Insgesamt * <br><br> ---- | 1 | RECHERCHIERTE SACHGEBIETE (Int. Cl.³) |

EPA Form 1503.2  06.78